# EUROPÄISCHE PATENTSCHRIFT

(11) **EP 0 799 848 B1**
(45) Veröffentlichungstag und Bekanntmachung des Hinweises auf die Patenterteilung: **26.09.2001**
(21) Anmeldenummer: 97103928.4
(22) Anmeldetag: 10.03.1997
(51) Int. Cl.: C08G 59/30, C08G 59/40

(54) **Phosphormodifizierte Epoxidharze aus Epoxidharzen und phosphorhaltigen Verbindungen**
Phosphorus modified epoxy resins from epoxy resins and phosphorus containing compounds
Résines époxydes modifiées par du phosphore à partir de résines époxydes et des composés contenant du phosphore

(30) Priorität: 01.04.1996 DE 19613061
(43) Veröffentlichungstag der Anmeldung: 08.10.1997
(73) Patentinhaber: Clariant GmbH, 65929 Frankfurt am Main (DE)
(72) Erfinder: Hörold, Sebastian, Dr., 50374 Erftstadt (DE); Schmitz, Hans-Peter, 50321 Brühl (DE)

(56) Entgegenhaltungen:
- DE-A- 1 570 439
- DE-A- 2 652 007
- DE-A- 2 652 052
- CHEMICAL ABSTRACTS, vol. 108, no. 18, 2.Mai 1988 Columbus, Ohio, US; abstract no. 151779, HARA. K. E.A.: "Flame-retardant polyester-epoxy adhesive compositions" XP002031553 & JP 62 218 465 A (TORAY INDUSTRIES) 25.September 1987
- CHEMICAL ABSTRACTS, vol. 70, no. 26, 30.Juni 1969 Columbus, Ohio, US; abstract no. 115898, VASIL'EVA E.A.: "Epoxy-foams preparationwith boron compounds as hardeners" XP002031554 & SU 234 660 A (VLADIMIR SCIENTIFIC-RESEARCH INSTITUTE OF SYNTHETIC RESINS)
- CHEMICAL ABSTRACTS, vol. 118, no. 22, 31.Mai 1993 Columbus, Ohio, US; abstract no. 214297, TAKAHASHI, K: "Agents for imparting the flame retardance to thermoplastics" XP002031555 & JP 04 300 968 A (DAINIPPON KOKAI ) 23.Oktober 1992
- CHEMICAL ABSTRACTS, vol. 72, no. 24, 15.Juni 1970 Columbus, Ohio, US; abstract no. 122417, NIKOLAEV E.A.: "Curing of epoxy resins" XP002031562 & SU 255 553 A (LENSOVET TECHNOLOGICAL INSTITUTE)

## Beschreibung

Die vorliegende Erfindung betrifft phosphormodifizierte Epoxidharze, ein Verfahren zu ihrer Herstellung und ihre Verwendung.

Epoxidharze werden heute zur Herstellung von Formmassen und Beschichtungen mit hohen thermischen, mechanischen und elektronischen Eigenschaften eingesetzt. Sie sind geeignet zum Verguß von elektrischen bzw. elektronischen Bauteilen und für Tränk- und Imprägnierprozesse. In der Elektrotechnik werden die verwendeten Epoxidharz-Formmassen überwiegend flammwidrig ausgerüstet.

Epoxidharz-Formmassen werden im allgemeinen mit bromhaltigen aromatischen Verbindungen, insbesondere Tetrabrombisphenol A, flammwidrig ausgerüstet. Werden ausschließlich bromierte Flammschutzmittel eingesetzt, so wird ein Bromgehalt von etwa 20 % benötigt, um ein Selbstverlöschen der Formmassen zu gewährleisten. Als Synergist wird häufig Antimontrioxid verwendet. Im Brandfall wird Bromwasserstoff freigesetzt, was zu Schäden durch Korrrosion führen kann. Unter ungünstigen Bedingungen können auch polybromierte Dibenzodioxine und Furane entstehen. Es besteht von daher ein Bedarf an Epoxidharz-Formmassen, die die geforderte Flammwidrigkeit ohne Zusatz bromierter Verbindungen erreichen.

Zur flammwidrigen Ausrüstung von Epoxidharz-Formmassen wurden Füllstoffe mit Löschwirkung wie Aluminiumoxidhydrat (DE-A-35 40 524) vorgeschlagen. Auch durch den Zusatz von Ammoniumpolyphosphat, gegebenenfalls in Kombination mit Aluminiumoxidhydrat, kann eine hinreichende Flammwidrigkeit erreicht werden. Anstelle von Ammoniumpolyphosphat kann auch roter Phosphor verwendet werden (DE-A-17 45 796).

Nachteilig bei allen als Füllstoff vorliegenden Flammschutzmitteln ist, daß keine Transparenz der Materialien erhalten wird. Es wurden bereits zahlreiche flüssige phosphororganische Verbindungen als flammhemmende Kunststoffzusätze vorgeschlagen. Nachteilig bei diesen Systemen ist aber der ausgeprägte "Weichmachereffekt" dieser Zusätze. Bei gehärteten Epoxidharzen äußert sich der weichmachende Effekt in einer starken Herabsetzung der Glasübergangstemperatur.

In der Literatur bekannt sind auch phosphormodifizierte Epoxidharze, die durch Umsetzung von Polyepoxidverbindungen mit Anhydriden von Phosphonsäuren oder Phosphinsäuren erhalten werden und sich durch gute flammwidrige Eigenschaften auszeichnen (DE-A-43 08 185).

Die flammwidrige Ausstattung von Epoxidharzen mit epoxidfunktionellen Phosphonsäureestern ist bereits beschrieben (EP-A-0 384 939). Nachteilig bei diesen Systemen ist der hohe Syntheseaufwand derartiger Phosphonsäureester.

Es ist Aufgabe der vorliegenden Erfindung, ein flammwidriges Epoxidharz zur Verfügung zu stellen, das sich leicht handhaben läßt und das auf einfache Art und Weise herstellbar ist.

Gelöst wird diese Aufgabe durch ein phosphormodifiziertes Epoxidharz mit einem Epoxid-wert von 0 bis 1,0 mol/100g, enthaltend Struktureinheiten, die sich ableiten von
(A) Polyepoxidverbindungen mit mindestens zwei Epoxidgruppen pro Molekül und
(B) Diphosphinsäuren.

Bevorzugt beträgt der Epoxidwert des phosphormodifizierten Epoxidharzes 0 bis 0,6 mol/100g beträgt.

Das erfindungsgemäße phosphormodifizierte Epoxidharz ist weiterhin, dadurch gekennzeichnet, daß die Diphosphinsäuren der Formel (I) entsprechen, in der 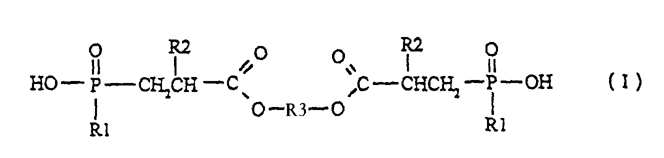 R1 eine Alkyl- oder Arylgruppe mit 1 bis 10 C-Atomen, R2 Wasserstoff oder eine Alkyl gruppe mit 1 bis 4 C-Atomen und R3 eine Alkylen-, Cycloalkylen- oder Arylengruppe mit 2 bis 20 C-Atomen bedeutet.

Bevorzugt beträgt der Phosphorgehalt 0,5 bis 9 Gew.-%, bezogen auf das Epoxidharz.

Bevorzugt enthält das phosphormodifizierte Epoxidharz im Mittel mindestens eine Epoxidgruppe.

Die vorliegende Aufgabe wird ebenfalls gelöst durch ein Verfahren zur Herstellung von phosphormodifizierten Epoxidharzen aus einem Epoxidharz und einer phosphorhaltigen Verbindung nach Formel (I), dadurch gekennzeichnet, daß man die Polyepoxidverbindung gemäß (A) und die Diphosphinsäure gemäß (B) miteinander umsetzt.

Bevorzugt erfolgt die Umsetzung in einem Lösungsmittel.

Bevorzugt werden aprotische, polare Lösungsmittel, wie N-methylpyrrolidon, Dimethylformamid, Tetrahydrofuran, Dioxan, Dialkylether, Glykolether, Ketone und/oder Ester eingesetzt.

Ebenfalls bevorzugt werden als Lösungsmittel halogenierte Kohlenwasserstoffe, aliphatische, cycloaliphatische und/oder aromatische Kohlenwasserstoffe, einzeln oder als Gemische, eingesetzt.

Die Umsetzung erfolgt bevorzugt bei Temperaturen zwischen -10 bis +200 °C.

Besonders bevorzugt erfolgt die Umsetzung bei Temperaturen von 70 bis 130 °C.

Bevorzugt beträgt das Äquivalentverhältnis zwischen Polyepoxidverbindung (A) und Diphosphinsäure (B) 1:0,1 bis 1:1.

Die Erfindung betrifft auch die Verwendung der erfindungsgemäßen phosphormodifizierten Epoxidharze zur Herstellung von Formkörpern, Beschichtungen oder Laminaten.

Schließlich betrifft die Erfindung Formkörper, Beschichtungen oder Laminate, hergestellt unter Verwendung der erfindungsgemäßen phosphormodifizierten Epoxidharze.

Die erfindungsgemäßen, phosphormodifizierten Epoxidharze zeichnen sich durch eine gute Lagerstabilität, auch in Lösung, Schmelzbereiche von 70 bis 100 °C und Glastemperaturen von oberhalb 40 °C aus und sind von daher auch gut geeignet zur Herstellung von Laminaten über sogenannte Prepregs.

Bei der erfindungsgemäßen Herstellung der phosphormodifizierten Epoxidharze werden eine Polyepoxidverbindung mit mindestens zwei Epoxidgruppen pro Molekül und ein 2,5-Dioxo-1,2-oxaphospholan der allgemeinen Formel (II), 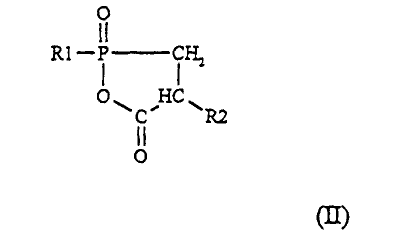 worin R1 und R2 die gleiche Bedeutung wie in Formel (I) haben, vorgelegt und erwärmt, bis eine homogene Schmelze entstanden ist. Anschließend wird ein Diol der allgemeinen Formel HO-R3-OH (III), worin R die gleiche Bedeutung wie in Formel (I) hat, dazugetropft. Alternativ kann das Diol auch direkt dazugegeben werden. Aus dem Diol und dem 2,5-Dioxo-1,2-oxaphospholan entsteht eine Diphosphinsäure nach Formel (I), die direkt in das Epoxidharz einreagiert.

Das verwendete Diol nach Formel (III) kann beispielsweise Ethylenglycol, Propandiol, Butandiol, Cyclohexandiol, Resorcin oder Hydrochinon sein.

Die Herstellung des 2,5-Dioxo-1,2-oxaphospholans nach Formel (II) kann, wie in der DE-A-25 28 420 beschrieben, aus Dihalogenphosphinen und einer ungesättigten Carbonsäure und anschließender Chlorabspaltung, beispielsweise durch Wasser oder Essigsäure, erfolgen.

Die erfindungsgemäß eingesetzten halogenfreien Epoxidverbindungen (im folgenden auch Polyepoxidverbindungen genannt) können gesättigt oder ungesättigt sowie aliphatisch, cycloaliphatisch, aromatisch und/oder heterocyclisch sein. Sie können weiterhin solche Substituenten enthalten, die unter den Mischungs- oder Reaktionsbedingungen keine störenden Nebenreaktionen verursachen, beispielsweise Alkyl- oder Arylsubstituenten, Ethergruppierungen oder ähnliche. Es können auch Gemische verschiedener Polyepoxidverbindungen verwendet werden. Das mittlere Molekulargewicht Mₙ dieser Polyepoxidverbindungen kann bis zu etwa 9000 betragen, liegt jedoch im allgemeinen bei etwa 150 bis 4000.

Beispielsweise handelt es sich bei diesen Polyepoxidverbindungen um Polyglycidylether auf Basis von mehrwertigen, vorzugsweise zweiwertigen Alkoholen, Phenolen, Hydrierungsprodukten dieser Phenole und/oder von Novolaken (Umsetzungsprodukte von ein- oder mehrwertigen Phenolen, wie Phenol und/oder Kresole, mit Aldehyden, insbesondere Formaldehyd in Gegenwart saurer Katalysatoren), die man in bekannter Weise, beispielsweise durch Umsetzung der jeweiligen Polyole mit Epichlorhydrin, erhält.

Als mehrwertige Phenole sind hier beispielsweise zu nennen: Resorcin, Hydrochinon, 2,2-Bis(4-hydroxyphenyl)propan (Bisphenol A), Isomerengemische des Dihydroxydiphenylmethans (Bisphenol F), 4,4'-Dihydroxydiphenylcyclohexan, 4,4'-Dihydroxy-3,3'-dimethyldiphenylpropan, 4,4'-Dihydroxydiphenyl, 4,4'-Dihydroxybenzophenon, Bis(4-hydroxyphenyl) 1,1-ethan,Bis(4-hydroxyphenyl)1,1'-isobutan, Bis(4-hydroxy-tert.-butylphenyl)2,2-propan, Bis(2-hydroxynaphthyl)methan, 1,5-Dihydroxynaphthalin, Tris(4-hydroxyphenyl)methan, Bis(4-hydroxyphenyl)1,1'-ether. Bisphenol A und Bisphenol F sind hierbei bevorzugt.

Auch die Polyglycidylether von mehrwertigen aliphatischen Alkoholen sind als Polyepoxidverbindung geeignet. Als Beispiele derartiger mehrwertiger Alkohole seien 1,4-Butandiol, 1,6-Hexandiol, Polyalkylenglykole, Glycerin, Trimethylolpropan, Bis(4-hydroxycyclohexyl)2,2-propan und Pentaerythrit genannt.

Weiter kommen als Polyepoxidverbindungen auch (Poly)glycidester in Frage, die man erhält durch Umsetzung von Epichlorhydrin oder ähnlichen Epoxyverbindungen mit einer aliphatischen, cycloaliphatischen oder aromatischen Polycarbonsäure, wie Oxalsäure, Adipinsäure, Glutarsäure, Phthal-, Isophthal-, Terephthal-, Tetrahydrophthal- oder Hexahydrophthalsäure, 2,6-Naphthalindicarbonsäure und dimerisierte Fettsäuren. Beispiele hierfür sind Terephthalsäurediglycidylester und Hexahydrophthalsäurediglycidylester.

Polyepoxidverbindungen, die die Epoxidgruppen in statistischer Verteilung über die Molekülkette enthalten und die durch Emulsions-Copolymerisation unter Verwendung von olefinisch ungesättigten, diese Epoxidgruppen enthaltenden Verbindungen hergestellt werden können, wie z.B. Glycidylester der Acryl- oder Methacrylsäure, können in manchen Fällen vorteilhaft eingesetzt werden.Weitere verwendbare Polyepoxidverbindungen sind beispielsweise solche auf der Basis heterocyclischer Ringsysteme, wie z.B. Hydantoinepoxidharze, Triglycidylisocyanurat und/oder dessen Oligomeren, Triglycidyl-p-aminophenol, Triglycidyl-p-aminodiphenylether, Tetraglycidyldiaminodiphenylmethan, Tetraglycidyldiaminodiphenylether, Tetrakis(4-glycidoxyphenyl)ethan, Urazolepoxide, Uracilepoxide, oxazolidinonmodifizierte Epoxidharze.

Weiterhin Polyepoxide auf der Basis von aromatischen Aminen, wie Anilin, beispielsweise N,N-Diglycidylanilin, Diaminodiphenylmethan und N,N'-Dimethylaminodiphenylmethan oder -sulfon. Weitere geeignete Polyepoxidverbindungen sind im "Handbook of Epoxy Resins" von Henry Lee und Kris Neville, McGraw-Hill Book Company, 1967, in der Monographie von Henry Lee "Epoxy Resins", American Chemical Society, 1970, in Wagner/Sarx, "Lackkunstharze", Carl Hanser Verlag (1971), 5. Auflage, 174 ff., in der "Angew. Makromol. Chemie", Bd. 44 (1975), Seiten 151 bis 163, in der DE-A-27 57 733 sowie in der EP-A-0 384 939 beschrieben, auf die hiermit Bezug genommen wird.

Bevorzugt eingesetzte Polyepoxidverbindungen sind Bisglycidylether auf Basis von Bisphenol A, Bisphenol F und Bisphenol S (Umsetzungsprodukte dieser Bisphenole und Epichlor(halogen)hydrin) oder deren Oligomere, Polyglycidylether von Phenol/Formaldehyd- und/oder Kresol/Formaldehyd-Novolake sowie Diglycidylester der Phthal-, Isophthal-, Terephthal-, Tetrahydrophthal- und/oder Hexahydrophthalsäure sowie der Trimellithsäure, N-Glycidylverbindungen von aromatischen Aminen und heterocyclischen Stickstoffbasen, wie N,N-Diglycidylanilin, N,N,O-Triglycidyl-p-aminophenol, Triglycidylisocyanurat und N,N,N',N'-Tetraglycidylbis(p-aminophenyl)methan, Hydantoin-Epoxidharze und Aracid-Epoxidharze sowie Di- und Polyglycidylverbindungen von mehrwertigen aliphatischen Alkoholen, wie 1,4-Butandiol, Trimethylolpropan und Polyalkylenglykolen.

Des weiteren sind auch oxazolidinonmodifizierte Epoxidharze geeignet. Derartige Verbindungen sind bereits bekannt (siehe: "Angew. Makromol. Chem.", Bd. 44 (1975), Seiten 151 bis 163, sowie US-PS 3 334 110); beispielhaft sei hierfür das Umsetzungsprodukt von Bisphenol-A-diglycidylether mit Diphenylmethandiisocyanat (in Gegenwart eines geeigneten Beschleunigers) genannt. Die Polyepoxidharze können bei der Herstellung der erfindungsgemäßen Überzugsmasse einzeln oder im Gemisch vorliegen.

Der Ausdruck "Härten", wie er hier gebraucht wird, bedeutet die Umwandlung der löslichen, schmelzbaren Polyepoxide in feste, unlösliche und unschmelzbare, dreidimensional vernetzte Produkte, in der Regel unter gleichzeitiger Formgebung, etwa zu Imprägnierungen, Beschichtungen und Verklebungen.

Als Härter können bespielsweise aliphatische, cycloaliphatische, aromatische und heterocyclische Amine, wie Bis(4-aminophenyl)methan, Anilin-Formaldehyd-Harze, Bis(4-aminophenyl)sulfon, Ethylendiamin, Propan-1,3-diamin, Hexamethylendiamin, Diethylentriamin, Triethylentetramin, 2,2,4-Trimethylhexan-1,6-diamin, m-Xylylendiamin, Bis(4-aminocyclohexyl)methan, 2,2-Bis(4-aminocyclohexyl)propan, 3-Aminomethyl-3,55-trimethylcyclohexylamin (Isophorondiamin), Polyamidoamine, Polyphenole, wie Hydrochinon, Resorcin, 2,2-Bis(4-hydroxyphenyl)propan (Bisphenol A) und Phenol-Aldehyd-Harze, Polycarbonsäuren und deren Anhydride, wie zum Beispiel Phtalsäureanhydrid, Tetrahydrophtalsäureanhydrid, Hexahydrophtalsäureanhydrid, Pyromellithsäuredianhydrid eingesetzt werden. Darüber hinaus können auch katalytisch wirkende Härtungsmittel wie Cyanguanidine oder Friedel-Crafts-Katalysatoren wie Bortrifluorid verwendet werden.

Werden Amine als Härtungsmittel verwendet, so werden diese normalerweise in 0,75 bis 1,25 Äquivalenten pro Epoxidäquivalent eingesetzt. Bei Polycarbonsäuren der deren Anhydriden werden 0,4 bis 1,1 Äquivalente pro Epoxidäquivalent verwendet.

Als Beschleuniger kommen vor allem Imidazolderivate, beispielsweise 2-Methylimidazol, 2-Phenylimidazol und 2-Heptadecylimidazol in Frage; weiterhin Phosphine, Metallseifen und Acetylacetonate.

Als Reaktiv-Verdünner kommen beispielsweise mono- oder polyfunktionelle, niedermolekulare Alkohole, die mit Epichlorhydrin umgesetzt werden, in Frage.

Durch Variation des Äquivalentverhältnisses von Polyepoxidverbindung zu Diphosphinsäure nach Formel (I) läßt sich der Phosphorgehalt des erfindungsgemäßen Harzes einstellen. Bevorzugt liegt das Äquivalentverhältnis zwischen 1: 0,1 und 1: 0,8 und besonders bevorzugt zwischen 1:0,1 und 1:0,4. Durch die Umsetzung des EP-Harzes mit einer phosphorhaltigen Dicarbonsäuren oder einem phosphorhaltigen Carbonsäureanhydrid wird ein noch schmelzbares und/oder lösliches, phosphormodifiziertes Epoxidharz erhalten, welches lagerstabil, wahlweise auch in Lösung, und einfach zu handhaben ist.

Als Lösungsmittel für das Verfahren eignen sich etwa N-methylpyrrolidon, Dimethylformamid, Ether wie etwa Diethylether, Tetrahydrofuran, Dioxan, Ethylglykolether, Propylenglykolether, Butylglykolether von Monoalkoholen mit einem ggf. verzweigten Alkylrest von 1 bis 6 Kohlenstoffatomen.

Andere Lösungsmittel sind z.B. Ketone, wie etwa Aceton, Methylethylketon, Methylisopropylketon, Methylisobutylketon, Cyclohexanon und ähnliche, aber auch Ester, wie Ethylacetat, Butylacetat, Ethylenglycolacetat und Methoxypropylacetat können eingesetzt werden.

Weitere geeignete Lösungsmittel sind halogenierte Kohlenwasserstoffe sowie cycloaliphatische und/oder aromatische Kohlenwasserstoffe, bevorzugt sind dabei Hexan, Heptan, Cyclohexan, Toluol sowie Dixylole. Es ist möglich, diese Lösemittel einzeln oder im Gemisch einzusetzen.

Bevorzugt sind die Epoxidharz-Formmassen durch Glasgewebe oder Glasfasern verstärkt. Die Epoxidharz-Formmassen können auch mit Füllstoffen wie Quarzmehl oder Aluminiumoxidhydrat ausgerüstet werden.

Die erfindungsgemäßen Epoxidharz-Formmassen können zur Oberflächenbeschichtung verwendet werden. Sie können für den Verguß elektrischer Bauteile, für Laminate sowie für Klebstoffe verwendet werden.

Nachfolgend wird die Erfindung durch Beispiele erläutert. In den Beispielen wurde eine Phosphorverbindung nach Formel (IV) verwendet:

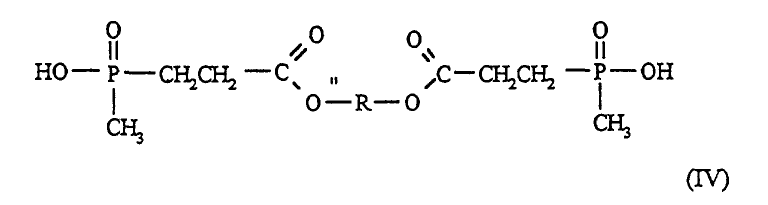

### Beispiel 1

In einem 500 ml Fünfhalskolben mit Rührerwelle, Tropftrichter, Rückflußkühler und Thermometer werden 147 g eines Bisphenol-A-bisglycidylethers mit einem Epoxidwert von 0,55 mol/100 g und 54 g 2-Methyl-2,5-dioxo-1,2-oxaphospholan (0,4 mol) vorgelegt und unter Rühren auf 110 °C erwärmt. Während 30 min werden 12,6 g Ethylenglycol (0,2 mol) bei 110 °C zugetropft. Nach weiteren 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxidwert von 0,16 mol/100g und einem Phosphorgehalt von 5,7 Gew.-%.

### Beispiel 2

In einem 500 ml Fünfhalskolben mit Rührerwelle, Tropftrichter, Rückflußkühler und Thermometer werden 147 g eines Bisphenol-A-bisglycidylethers mit einem Epoxidwert von 0,55 mol/100 g und 54 g 2-Methyl-2,5-dioxo-1,2-oxaphospholan (0,4 mol) in 54 ml Methylethylketon vorgelegt und unter Rühren auf 80 °C erwärmt. Während 30 min werden 12,6 g Ethylenglycol (0,2 mol) zugetropft. Nach weiteren 30 min Rühren wird eine klare Lösung erhalten. Es wird noch 5 h bei 80 °C gerührt. Man erhält eine 80 Gew.-%ige Lösung eines farblosen Epoxidharzes mit einem Epoxidwert von 0,13 mol/100g und einem Phosphorgehalt von 4,6 Gew.-%.

### Beispiel 3

In einem 500 ml Fünfhalskolben mit Rührerwelle, Tropftrichter, Rückflußkühler und Thermometer werden 124 g eines Bisphenol-A-bisglycidylethers mit einem Epoxidwert von 0,55 mol/100 g und 46 g 2-Methyl-2,5-dioxo-1,2-oxaphospholan (0,34 mol) vorgelegt und unter Rühren auf 110 °C erwärmt. Während 30 min werden 12,9 g 1,3-Propandiol (0,17 mol) bei 110 °C zugetropft. Nach weiteren 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxid-wert von 0,19 mol/100g und einem Phosphorgehalt von 5,8 Gew.-%.

### Beispiel 4

In einem 500 ml Fünfhalskolben mit Rührerwelle, Tropftrichter, Rückflußkühler und Thermometer werden 123 g eines Bisphenol A-bisglycidylethers mit einem Epoxidwert von 0,55 mol/100 g und 45 g 2-Methyl-2,5-dioxo-1,2-oxaphospholan (0,34 mol) vorgelegt und unter Rühren auf 110 °C erwärmt. Während 30 min werden 18 g Diethylenglycol (0,17 mol) bei 110 °C zugetropft. Nach weiteren 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxid-wert von 0,21 mol/100g und einem Phosphorgehalt von 5,6 Gew.-%.

### Beispiel 5

In einem 500 ml Fünfhalskolben mit Rührerwelle, Tropftrichter, Rückflußkühler und Thermometer werden 102 g eines Bisphenol A-bisglycidylethers mit einem Epoxidwert von 0,55 mol/100 g und 38 g 2-Methyl-2,5-dioxo-1,2-oxaphospholan (0,28 mol) vorgelegt und unter Rühren auf 110 °C erwärmt. Anschließend werden 15,5 g Hydrochinon (0,14 mol) dazugegeben. Nach 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxidwert von 0,21 mol/100g und einem Phosphorgehalt von 5,6 Gew.-%.

### Beispiel 6

In einem 500 ml Fünfhalskolben mit Rührerwelle, Tropftrichter, Rückflußkühler und Thermometer werden 102 g eines Bisphenol A-bisglycidylethers mit einem Epoxidwert von 0,55 mol/100 g und 38 g 2-Methyl-2,5-dioxo-1,2-oxaphospholan (0,28 mol) vorgelegt und unter Rühren auf 110 °C erwärmt. Anschließend werden 15,5 g Resorcin (0,14 mol) dazugegeben. Nach 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxidwert von 0,19 mol/100g und einem Phosphorgehalt von 5,6 Gew.-%.

### Brandtest

Das phoshormodifizierte Harz wurde mit der äquivalenten Menge Dicyandiamid (® Dyhard 100 SF, mikronisiertes Dicyandiamid, SKW Trostberg AG) intensiv vermischt und in einer Teflonform im Trockenschrank bei 150 - 180 °C während 4 h ausgehärtet. Als Beschleuniger wurde ein Imidazol (® Dyhard MI, Methylimidazol, SKW Trostberg AG) verwendet. Die Prüfung des Brandverhaltens wurde nach der Vorschrift von Underwriters Laboratories "Test for Flammability of Plastic Materials - UL 94" in der Fassung vom 02.05.1975 an Prüfkörpern von 127 mm Länge, 12,7 mm Breite und verschiedener Dicke durchgeführt. Der Sauerstoffindex wurde in einer Apparatur nach ASTM-D 2863-74 bestimmt.

| Phosphormod. Harz | Dicyandiamid | Imidazol-Beschleuniger | Sauerstoffindex | Nachbrennzeit | UL 94 Klassifizierung |
|---|---|---|---|---|---|
| 160 g Harz nach Beispiel 1 | 3,95 g | 0,34 g | 30,2 | <1', <1' | V-0 |
| 140 g Harz nach Beispiel 2 | 3,51 g | 0,29 g | 29,4 | <1', <1' | V-0 |
| 120 g Harz nach Beispiel 5 | 3,28 g | 0,28 g | 29,5 | <1', <2' | V-0 |

## Patentansprüche

1. Verfahren zur Herstellung phosphormodifizierter Epoxidharze, **dadurch gekennzeichnet, dass** man eine Polyepoxidverbindung mit mindestens zwei Epoxidgruppen pro Molekül mit einem 2,5-Dioxo-1,2-oxaphospholan der allgemeinen Formel (II) und einem Diol der allgemeinen Formel (III) 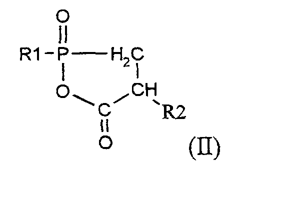
HO-R3-OH (III)
wobei R1 eine Alkyl- oder Arylgruppe mit 1 bis 10 C-Atomen, R2 Wasserstoff oder eine Alkylgruppe mit 1 bis 6 C-Atomen und R3 eine Alkylen-, Cycloalkylen- oder Arylengruppe mit 2 bis 20 C-Atomen bedeutet, umsetzt.

2. Verfahren nach Anspruch 1, **dadurch gekennzeichnet, dass** das phosphormodifizierte Epoxidharz einen Epoxid-Wert von 0 bis 1,0 mol/100g aufweist.

3. Verfahren nach Anspruch 1, **dadurch gekennzeichnet, dass** das phosphormodifizierte Epoxidharz einen Epoxid-Wert von 0 bis 0,6 mol/100g aufweist.

4. Verfahren nach einem oder mehreren der Ansprüche 1 bis 3, **dadurch gekennzeichnet, dass** das phosphormodifizierte Epoxidharz einen Phosphorgehalt von 0,5 bis 9 Gew.-%, bezogen auf das Epoxidharz, aufweist.

5. Verfahren nach einem oder mehreren der Ansprüche 1 bis 4, **dadurch gekennzeichnet, dass** das phosphormodifizierte Epoxidharz im Mittel mindestens eine Epoxidgruppe aufweist.

6. Verfahren nach einem oder mehreren der Ansprüche 1 bis 5, **dadurch gekennzeichnet, dass** man in einem Lösungsmittel umsetzt.

7. Verfahren nach einem oder mehreren der Ansprüche 1 bis 6, **dadurch gekennzeichnet, dass** als aprotische, polare Lösungsmittel N-methylpyrrolidon, Dimethylformamid, Tetrahydrofuran, Dioxan, Dialkylether, Glykolether, Ketone und/oder Ester eingesetzt werden.

8. Verfahren nach einem oder mehreren der Ansprüche 1 bis 6, **dadurch gekennzeichnet, dass** als Lösungsmittel halogenierte Kohlenwasserstoffe, aliphatische, cycloaliphatische und/oder aromatische Kohlenwasserstoffe, einzeln oder als Gemische, eingesetzt werden.

9. Verfahren nach einem oder mehreren der Ansprüche 1 bis 8, **dadurch gekennzeichnet, dass** bei Temperaturen zwischen -10 bis +200 °C umgesetzt wird.

10. Verfahren nach einem oder mehreren der Ansprüche 1 bis 9, **dadurch gekennzeichnet, dass** bei Temperaturen zwischen 70 bis 130 °C umgesetzt wird.

11. Verfahren nach einem oder mehreren der Ansprüche 1 bis 6, **dadurch gekennzeichnet, dass** das Äquivalentverhältnis zwischen Polyepoxidverbindung und 2,5-Dioxo-1,2-oxaphospholan der allgemeinen Formel (II) 1:0,1 bis 1:1 beträgt.

12. Verwendung des nach dem Verfahren der Ansprüche 1 bis 11 hergestellten phosphormodifizierten Epoxidharzes zur Herstellung von Formkörpern, Beschichtungen oder Laminaten.

## Claims

1. A process for preparing phosphorus-modified epoxy resins, which comprises reacting a polyepoxide compound having at least two epoxide groups per molecule with a 2,5-dioxo-1,2-oxaphospholane of the formula (II) and a diol of the formula (III) 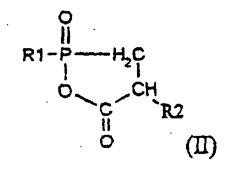
HO-R3-OH (III)
in which R1 is an alkyl or aryl group having 1 to 10 carbon atoms, R2 is hydrogen or an alkyl group having 1 to 6 carbon atoms, and R3 is an alkylene, cycloalkylene arylene group having 2 to 20 carbon atoms.

2. The process as claimed in claim 1, wherein the phosphorus-modified epoxy resin has an epoxide value of from 0 to 1.0 mol/100 g.

3. The process as claimed in claim 1, wherein the phosphorus-modified epoxy resin has an epoxide value of from 0 to 0.6 mol/100 g.

4. The process as claimed in one or more of claims 1 to 3, wherein the phosphorus-modified epoxy resin has a phosphorus content of from 0.5 to 9% by weight, based on the epoxy resin.

5. The process as claimed in one or more of claims 1 to 4, wherein the phosphorus-modified epoxy resin contains, on average, at least one epoxide group.

6. The process as claimed in one or more of claims 1 to 5, wherein the reaction takes place in a solvent.

7. The process as claimed in one or more of claims 1 to 6, wherein aprotic polar solvents employed are N-methylpyrrolidone, dimethylformamide, tetrahydrofuran, dioxane, dialkyl ethers, glycol ethers, ketones and/or esters.

8. The process as claimed in one or more of claims 1 to 6, wherein solvents employed are halogenated hydrocarbons, aliphatic, cycloaliphatic and/or aromatic hydrocarbons, individually or as mixtures.

9. The process as claimed in one or more of claims 1 to 8, wherein the reaction takes place at temperatures of between -10 and +200°C.

10. The process as claimed in one or more of claims 1 to 9, wherein the reaction takes place at temperatures of between 70 and 130°C.

11. The process as claimed in one or more of claims 1 to 6, wherein the ratio of equivalents between polyepoxide compound and 2,5-dioxo-1,2-oxa-phospholane of the formula (II) is from 1:0.1 to 1:1.

12. The use of the phosphorus-modified epoxy resin prepared by the method as claimed in claims 1 to 11 for the production of moldings, coatings or laminates.

## Revendications

1. Procédé pour la préparation de résines époxydes modifiées par du phosphore, **caractérisé en ce que**, l'on met à réagir un composé polyépoxyde ayant au moins deux groupes époxyde par molécule avec un 2,5-dioxo-1,2-oxa-phospholane de formule générale (II) et un diol de formule générale (III) 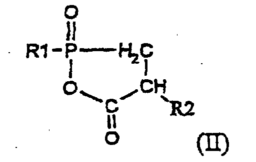
HO-R3-OH (III)
dans lesquelles R1 représente un groupe alkyle ou aryle ayant de 1 à 10 atomes de carbone, R2 représente un atome d'hydrogène ou un groupe alkyle ayant de 1 à 6 atomes de carbone et R3 représente un groupe alkylène, cycloalkylène ou arylène ayant de 2 à 20 atomes de carbone.

2. Procédé selon la revendication 1, **caractérisé en ce que** la résine époxyde modifiée par du phosphore présente un indice d'époxyde compris entre 0 et 1,0 mol/100 g.

3. Procédé selon la revendication 1, **caractérisé en ce que** la résine époxyde modifiée par du phosphore présente un indice d'époxyde compris entre 0 et 0,6 mol/100 g.

4. Procédé selon une ou plusieurs des revendications 1 à 3, **caractérisé en ce que** la résine époxyde modifiée par du phosphore présente un taux de phosphore de 0,5 à 9% en poids, par rapport à la résine époxyde.

5. Procédé selon une ou plusieurs des revendications 1 à 4, **caractérisé en ce que** la résine époxyde modifiée par du phosphore présente en moyenne au moins un groupe époxyde.

6. Procédé selon une ou plusieurs des revendications 1 à 5, **caractérisé en ce qu'**on effectue la réaction dans un solvant.

7. Procédé selon une ou plusieurs des revendications 1 à 6, **caractérisé en ce qu'**on utilise comme solvant aprotique, polaire, la N-méthylpyrrolidone, le diméthyl-formamide, le tétrahydrofurane, le dioxane, le dialkyléther, le glycoléther, les cétones et/ou les esters.

8. Procédé selon une ou plusieurs des revendications 1 à 6, **caractérisé en ce qu'**on utilise comme solvant des hydrocarbures halogénés, des hydrocarbures aliphatiques, cycloaliphatiques et/ou aromatiques, seuls ou sous forme de mélanges.

9. Procédé selon une ou plusieurs des revendications 1 à 8, **caractérisé en ce qu'**on effectue la réaction à des températures comprises entre -10 et +200°C.

10. Procédé selon une ou plusieurs des revendications 1 à 9, **caractérisé en ce qu'**on effectue la réaction à des températures comprises entre 70 et +130°C.

11. Procédé selon une ou plusieurs des revendications 1 à 6, **caractérisé en ce que** le rapport équivalent entre le composé polyépoxyde et le 2,5-dioxo-1,2-oxaphospholane de formule générale (II) s'élève entre 1 : 0,1 et 1 : 1.

12. Utilisation de la résine époxyde modifiée par du phosphore préparée selon le procédé des revendications 1 à 11 pour la fabrication de pièces moulées, de revêtements ou de stratifiés.
